# EUROPEAN PATENT APPLICATION

(11) **EP 4 589 057 A1**
(43) Date of publication of application: **23.07.2025**
(21) Application number: 23865060.0
(22) Date of filing: 12.07.2023
(51) Int. Cl.: C30B 29/38, C23C 16/34, C30B 25/18, C30B 29/36, H01L 21/20, H01L 21/205

(54) **SINGLE CRYSTAL SILICON SUBSTRATE EQUIPPED WITH NITRIDE SEMICONDUCTOR LAYER, AND METHOD FOR MANUFACTURING SINGLE CRYSTAL SILICON SUBSTRATE EQUIPPED WITH NITRIDE SEMICONDUCTOR LAYER**

(30) Priority: 16.09.2022 JP 2022147942
(71) Applicant: Shin-Etsu Handotai Co., Ltd., Tokyo 100-0004 (JP)
(72) Inventor: MATSUBARA, Toshiki, Nishishirakawa-gun, Fukushima 961-8061 (JP); TSUCHIYA, Keitaro, Annaka-shi, Gunma 379-0196 (JP); HAGIMOTO, Kazunori, Annaka-shi, Gunma 379-0196 (JP); ABE, Tatsuo, Nishishirakawa-gun, Fukushima 961-8061 (JP); OHTSUKI, Tsuyoshi, Nishishirakawa-gun, Fukushima 961-8061 (JP)
(74) Representative: Schicker, Silvia
(86) International application number: PCT/JP2023/025789
(87) International publication number: WO 2024/057698

(57) **Abstract**

The present invention is a single crystal silicon substrate with a nitride semiconductor layer, including: a single crystal silicon substrate; a 3C-SiC single crystal film epitaxially grown on the single crystal silicon substrate; and a nitride semiconductor layer epitaxially grown on the 3C-SiC single crystal film. Dislocations are formed throughout the single crystal silicon substrate, a length (dislocation length) of each of the dislocations when seen in a planar projection onto the single crystal silicon substrate is greater than or equal to 1 mm, and a density of the dislocations is greater than or equal to 10/cm². This provides a single crystal silicon substrate with a nitride semiconductor layer having a large diameter such as 200 mm or 300 mm that is made using a regular thickness Si substrate and has less warpage and especially no cracks, and a method for producing such a single crystal silicon substrate with a nitride semiconductor layer.

## Description

### TECHNICAL FIELD

The present invention relates to a single crystal silicon substrate with a nitride semiconductor layer and a method for producing a single crystal silicon substrate with a nitride semiconductor layer. More specifically, the present invention relates to a large diameter single crystal silicon substrate with a nitride semiconductor layer having a diameter of 200 mm, 300 mm, or more and a method for producing such a single crystal silicon substrate with a nitride semiconductor layer.

### BACKGROUND ART

Nitride semiconductor materials, such as GaN, are used in a vast range of applications, including highspeed switches, high-frequency devices, and power devices well as light-emitting devices such as LEDs, because they can operate at very high speeds due to the two-dimensional electron gas layer generated by self-polarization.

Against this background, nitride semiconductors (e.g., GaN) have been studied for a very long time, and in addition to freestanding substrates, there are substrates such as hetero-epitaxial substrates, which are obtained by epitaxially growing a nitride semiconductor layer on sapphire or other substrates. Among these, single crystal silicon substrates with a nitride semiconductor layer, which are made by forming a nitride semiconductor layer on single crystal silicon substrates, are seen as highly promising because the substrates are made of highly versatile single crystal silicon (Si) and are inexpensive and highly compatible with silicon (Si) device processes. To take advantage of such features, studies on growing a nitride semiconductor layer on single crystal silicon (Si) substrates with a large diameter of 300 mm have been very attractive and actively pursued.

When growing a nitride semiconductor layer such GaN on single crystal silicon (Si) substrates, a nitride semiconductor layer such as AlN is usually used as a buffer layer. In such cases, defects caused by melt-back of Al or Ga from the nitride semiconductor layer into the single crystal silicon (Si) substrate have been a problem. To prevent this problem, methods of growing SiC on single crystal silicon (Si) substrates, in particular growing 3C-SiC on single crystal silicon (Si) substrates in consideration of the ease of growth on single crystal silicon (Si) substrates, have been disclosed (see Patent Documents 1 to 4).

Problems associated with producing large diameter single crystal silicon substrates with a nitride semiconductor layer have been deformation and cracking of the single crystal silicon substrate (wafer) due to difference in linear expansion coefficient between Si and GaN. The growth of GaN requires high growth temperatures of 1000°C or higher, and during the cooling process of cooling from this growth temperature to room temperature, the deformation and cracking have occurred under the significant influence of the linear expansion coefficient. If the deformation is only warpage or the like, there are still ways to solve it. However, there is no solution to cracking of 300 mm large diameter single crystal silicon substrates (wafers), and as such this problem is very serious.

Also, even if there are no cracks immediately after growing and forming the nitride semiconductor layer, the single crystal silicon substrates (wafers) may be damaged due to stress during transportation or stress during device fabrication processes such as repeated chucking onto the stage, potentially resulting in the inability to fabricate the devices at high yields. The wafer damage is more than a wafer problem and may cause contamination and damage to the process equipment.

Known solutions to the problem of warpage and cracking include making Si substrates 1 mm or 1.5 mm thick. While increasing the thickness does mitigate warpage and cracking, the increased wafer thickness causes problems such as the inability to feed the substrates into device processes and the kerf loss resulting from ultimately grinding and polishing the Si substrates to thin films, failing to provide a fundamental solution.

### CITATION LIST

### PATENT LITERATURE

Patent Document 1: JP 5693946 B
Patent Document 2: JP 6450282 B
Patent Document 3: JP 6781095 B
Patent Document 4: JP 6266490 B

### NON PATENT LITERATURE

Non Patent Document 1: TI Technical White Paper, "Achieving GaN Products with Lifetime Reliability" (2021)

### SUMMARY OF INVENTION

### TECHNICAL PROBLEM

The present invention has been made to solve the above problems, and it is an object of the present invention to provide a single crystal silicon substrate with a nitride semiconductor layer having a large diameter such as 200 mm or 300 mm that is made using a regular thickness Si substrate and has less warpage and especially no cracks, and a method for producing such a single crystal silicon substrate with a nitride semiconductor layer.

### SOLUTION TO PROBLEM

The present invention has been made to achieve the above object and provides a single crystal silicon substrate with a nitride semiconductor layer, comprising: a single crystal silicon substrate; a 3C-SiC single crystal film epitaxially grown on the single crystal silicon substrate; and a nitride semiconductor layer epitaxially grown on the 3C-SiC single crystal film, wherein dislocations are formed throughout the single crystal silicon substrate, a length (dislocation length) of each of the dislocations when seen in a planar projection onto the single crystal silicon substrate is greater than or equal to 1 mm, and a density of the dislocations is greater than or equal to 10/cm².

Such a single crystal silicon substrate with a nitride semiconductor layer can be a single crystal silicon substrate with a nitride semiconductor layer having a large diameter such as 200 mm or 300 mm that is made using a regular thickness Si substrate and has less warpage and especially no cracks.

The thickness of the 3C-SiC single crystal film can be greater than or equal to 50 nm and less than or equal to 200 nm.

This more reliably provides a single crystal silicon substrate with a nitride semiconductor layer having a large diameter such as 200 mm or 300 mm that is made using a regular thickness Si substrate and has less warpage and especially no cracks. In addition, melt-back of Al or Ga can be sufficiently prevented.

The nitride semiconductor layer can be mainly composed of AlₓIn_{y}Ga_{1-x-y}N (0 ≤ x + y ≤ 1).

This provides a single crystal silicon substrate with a useful nitride semiconductor layer having a large diameter such as 200 mm or 300 mm that is made using a regular thickness Si substrate and has less warpage and especially no cracks.

The present invention has been made to achieve the above object and provides a method for producing a single crystal silicon substrate with a nitride semiconductor layer, comprising steps of: epitaxially growing a 3C-SiC single crystal film on a single crystal silicon substrate; and epitaxially growing a nitride semiconductor layer on the 3C-SiC single crystal film, wherein in the step of epitaxially growing the 3C-SiC single crystal film on the single crystal silicon substrate, a thickness of the 3C-SiC single crystal film is made less than or equal to 200 nm and then the step of epitaxially growing the nitride semiconductor layer on the 3C-SiC single crystal film is performed to thereby form dislocations throughout the single crystal silicon substrate, wherein a length (dislocation length) of each of the dislocations when seen in a planar projection onto the single crystal silicon substrate is greater than or equal to 1 mm, and a density of the dislocations is greater than or equal to 10/cm².

Such a method for producing a single crystal silicon substrate with a nitride semiconductor layer can produce a single crystal silicon substrate with a nitride semiconductor layer having a large diameter such as 200 mm or 300 mm that is made using a regular thickness Si substrate and has less warpage and especially no cracks.

### ADVANTAGEOUS EFFECTS OF INVENTION

As described above, the inventive single crystal silicon substrate with a nitride semiconductor layer can be a single crystal silicon substrate with a nitride semiconductor layer having a large diameter such as 200 mm or 300 mm that is made using a regular thickness Si substrate and has less warpage and especially no cracks.

The inventive method for producing a single crystal silicon substrate with a nitride semiconductor layer can produce a single crystal silicon substrate with a nitride semiconductor layer having a large diameter such as 200 mm or 300 mm that is made using a regular thickness Si substrate and has less warpage and especially no cracks.

### BRIEF DESCRIPTION OF DRAWINGS

FIG. 1 is a cross-sectional view illustrating an example single crystal silicon substrate with a nitride semiconductor layer;
FIG. 2 is a schematic flow diagram illustrating an example method for producing a single crystal silicon substrate with a nitride semiconductor layer;
FIG. 3 illustrates an example cross-sectional structure when 3C-SiC is grown;
FIG. 4 illustrates the results of XRT measurement for the substrate of Example 1;
FIG. 5 illustrates the results of XRT measurement for the substrate of Comparative Example 1; and
FIG. 6 illustrates the results of XRT measurement for the substrate of Comparative Example 2.

### DESCRIPTION OF EMBODIMENTS

The present invention is now detailed below; however, the present invention is not limited to the description given below.

As described above, a need has existed for a single crystal silicon substrate with a nitride semiconductor layer having a large diameter such as 200 mm or 300 mm that is made using a regular thickness Si substrate and has less warpage and especially no cracks and a method for producing such a single crystal silicon substrate with a nitride semiconductor layer.

The present inventors have earnestly studied on the above problems and consequently found that a single crystal silicon substrate with a nitride semiconductor layer having a large diameter such as 200 mm or 300 mm that is made using a regular thickness Si substrate and has less warpage and especially no cracks can be provided by a single crystal silicon substrate with a nitride semiconductor layer that includes: a single crystal silicon substrate; a 3C-SiC single crystal film epitaxially grown on the single crystal silicon substrate; and a nitride semiconductor layer epitaxially grown on the 3C-SiC single crystal film, where dislocations are formed throughout the single crystal silicon substrate, a length (dislocation length) of each of the dislocations when seen in a planar projection onto the single crystal silicon substrate is greater than or equal to 1 mm, and a density of the dislocations is greater than or equal to 10/cm². This finding has led to the completion of the present invention.

The structure in which SiC is grown on a Si substrate has already been disclosed by Patent Documents 1 to 4. In particular, Patent Document 4 discloses in para. [0030]-[0031] that the thickness of SiC is greater than or equal to 2 nm and less than or equal to 3.5 µm, but is silent regarding dislocation densities. The original idea behind using a thick Si substrate is to prevent the Si substrate from being deformed under stress. However, the inventive method instead introduces dislocations uniformly into the Si substrate to thereby mitigate deformation of the wafer. This is an unprecedented and completely novel concept and method.

GaN devices are lateral devices with a planar structure of heterojunction field effect transistors (HFET:Hetero Field Effect Transistor) that have a large saturation drift velocity and electron mobility by forming and utilizing a two-dimensional electron gas layer and thus allow a large current density to flow. Hence, as disclosed in Non Patent Document 1, the presence of a large number of dislocations in the Si substrate is not a problem as long as there are no dislocations in the GaN layer.

The single crystal silicon substrate with a nitride semiconductor layer and the method for producing a single crystal silicon substrate with a nitride semiconductor layer according to an embodiment of the present invention are described below.

### (Single Crystal Silicon Substrate with a Nitride Semiconductor Layer)

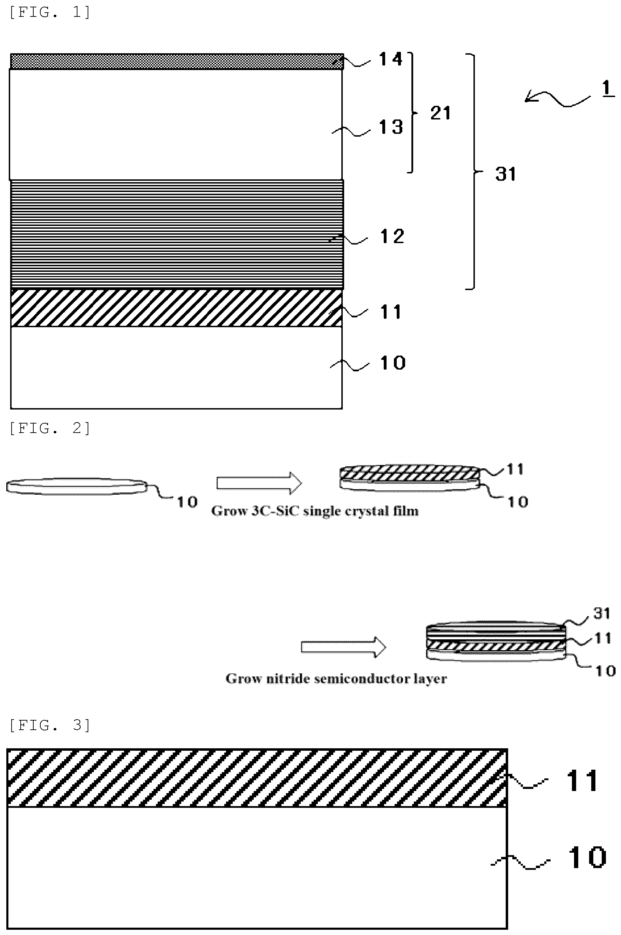

FIG. 1 is a cross-sectional view illustrating an example single crystal silicon substrate with a nitride semiconductor layer.

As shown in FIG. 1, the single crystal silicon substrate with a nitride semiconductor layer 1 includes a single crystal silicon substrate 10, a SiC single crystal film 11, and a nitride semiconductor layer 31.

### (Single Crystal Silicon Substrate)

The diameter and thickness of the single crystal silicon substrate 10 are not limited.

For example, the diameter can be 50 mm to 300 mm or more. In particular, large diameters such as 200 mm and 300 mm are preferred. The thickness is set to greater than or equal to 750 µm and less than or equal to 800 µm, based on the regular thickness of 775 µm. The use of the single crystal silicon substrate 10 with a thickness of greater than or equal to 750 µm and less than or equal to 800 µm not only eliminates the need for special processing and but also eliminates the need to worry about various defects caused by feeding thick wafers, which is a concern that arises when feeding wafers of difference thicknesses into device processes using the single crystal silicon substrate with a nitride semiconductor layer 1.

The plane orientation of the single crystal silicon substrate 10 is not limited.

For example, the plane orientation can be any of (100), (111), or (110). In particular, the plane orientation of the single crystal silicon substrate 10 is preferably (111). This is because (111) substrates have fewer directions in which dislocations are likely to slip (slip planes) than e.g., (100) substrates and are thus more resistant to wafer deformation.

### (3C-SiC Single Crystal Film)

The thickness of the 3C-SiC single crystal film 11 is preferably greater than or equal to 50 nm and less than or equal to 200 nm. The thickness of greater than or equal to 50 nm sufficiently prevents the melt-back of Al or Ga during the subsequent growth of a GaN or AlₓGa₁₋ₓN (0 < x ≤ 1) layer. The thickness of less than or equal to 200 nm allows dislocations to be introduced throughout the wafer during the subsequent growth of a GaN or AlₓGa₁₋ₓN (0 < x ≤ 1) layer. In addition, the dislocations generated by the 3C-SiC growth will not extend, so that there is no increased likelihood of cracking. The thickness is preferably about 100 nm.

### (Nitride Semiconductor Layer 31)

The nitride semiconductor layer 31 includes an intermediate layer 12 and a device layer 21.

The device layer 21 includes a GaN or AlₓGa₁₋ₓN (0 < x ≤ 1) layer 13 and an electron supply layer 14.

The structure of the nitride semiconductor layer 31 is merely exemplary and not limiting.

The nitride semiconductor constituting the nitride semiconductor layer 31 can be, for example, GaN, AlN, InN, AlGaN, InGaN, AlInN, AlScN, etc.

Preferably, the nitride semiconductor layer 31 is mainly composed of AlₓIn_{y}Ga_{1-x-y}N (0 ≤ x + y ≤ 1). For example, the nitride semiconductor layer 31 is mainly composed of: GaN at x = 0, y = 0; AlN at x = 1, y = 0; InN at x = 0, y = 1; or Al_{0.5}In_{0.5}N at x = 0.5, y = 0.5.

The thickness of the nitride semiconductor layer 31 is 0.1 to 10 µm and can be designed to suit the device.

### (Intermediate Layer 12)

The intermediate layer 12 serves as a buffer layer that is inserted to improve the crystallinity of the device layer 21 and to control the stress therein.

The intermediate layer 12 is fabricated using a nitride semiconductor. This allows the intermediate layer 12 to be fabricated using the same equipment as for the device layer 21.

### (Device Layer 21)

Desirably, the device layer 21 is a crystal with few crystal defects and few impurities such as carbon and oxygen in order to improve device characteristics.

In a high mobility transistor (HEMT) structure, the device layer 21 is composed of the GaN or AlₓGa₁₋ₓN (0 < x ≤ 1) layer 13 and the electron supply layer 14 made of AlGaN formed thereon.

### (GaN or AlₓGa₁₋ₓN (0 < x ≤ 1) Layer 13)

Since the GaN or AlₓGa₁₋ₓN (0 < x ≤ 1) layer 13 is a nitride semiconductor, the GaN or AlₓGa₁₋ₓN (0 < x ≤ 1) layer 13 can be fabricated using the same equipment as for the electron supply layer 14 and the intermediate layer 12.

### (Electron supply layer 14)

Since the electron supply layer 14 is also a nitride semiconductor, the electron supply layer 14 can be fabricated using the same equipment as for the GaN or AlₓGa₁₋ₓN (0 < x ≤ 1) layer 13 and the intermediate layer 12.

The single crystal silicon substrate with a nitride semiconductor layer 1 configured as described above has dislocations formed throughout the single crystal silicon substrate 10. The length (dislocation length) of each of the dislocations when seen in a planar projection onto the single crystal silicon substrate 10 is greater than or equal to 1 mm, and the density of the dislocations is greater than or equal to 10/cm².

By forming the dislocations at a high density such that dislocations with a length of greater than or equal to 1 mm are formed throughout the Si substrate at a density of greater than or equal to 10/cm², it is possible to reduce wafer warpage caused by the difference in linear expansion coefficient between GaN and Si.

GaN devices are lateral devices with a planar structure of heterojunction field effect transistors (HFET:Hetero Field Effect Transistor) that have a large saturation drift velocity and electron mobility by forming and utilizing a two-dimensional electron gas layer and thus allow a large current density to flow. Hence, as disclosed in Non Patent Document 1, the presence of a large number of dislocations in the Si substrate is not a problem as long as there are no dislocations in the GaN layer.

In this way, it is possible to provide a single crystal silicon substrate with a nitride semiconductor layer having a large diameter such as 200 mm or 300 mm that is made using a regular thickness Si substrate and has less warpage and especially no cracks.

The upper limit of the dislocation length is not limited, but is for example less than or equal to 40 mm. The upper limit of the dislocation density is also not limited, but is for example less than or equal to 50/cm².

### (Method for Producing a Single Crystal Silicon Substrate with a Nitride Semiconductor Layer)

FIG. 2 is a schematic flow diagram illustrating an example method for producing a single crystal silicon substrate with a nitride semiconductor layer.

As shown in FIG. 2, the method for producing the single crystal silicon substrate with a nitride semiconductor layer 1 according to an embodiment of the present invention includes: a step of epitaxially growing the 3C-SiC single crystal film 11 on the single crystal silicon substrate 10 (hereinafter referred to as the first step); and a step of epitaxially growing the nitride semiconductor layer 31 on the 3C-SiC single crystal film 11 (hereinafter referred to as the second step).

### (First Step)

### (Provision of a Single Crystal Silicon Substrate)

First, the single crystal silicon substrate 10 is provided.

For example, a single crystal silicon substrate with a thickness of 775 µm and a plane orientation of <111> is provided.

### (Oxide Film Removal)

The single crystal silicon substrate 10 is placed in a reduced pressure (RP)-CVD apparatus to remove a native oxide film on its surface by hydrogen baking (H₂ annealing).

The presence of any residual oxide film prevents the nucleation of SiC on the single crystal silicon substrate 10.

This H₂ annealing is preferably carried out at a temperature of 1000°C or higher and 1200°C or lower. If the temperature is below 1000°C, a longer treatment time is required to prevent residues of the native oxide film. Also, temperatures higher than 1200°C are undesirable due to concerns about the occurrence of slips originating from the wafer support of the RP-CVD apparatus. The pressure and duration of this H₂ annealing are not limited as long as the native oxide film can be removed.

### (SiC Nucleation and 3C-SiC Single Crystal Film Formation)

FIG. 3 illustrates an example cross-sectional structure when a 3C-SiC single crystal film is grown.

While a carbonizing gas such as propane gas is introduced as a raw material gas, the temperature is gradually raised from the range of 300°C or more and 950°C or less to the range of 1000°C or more and below 1200°C. This causes the nucleation of SiC and the subsequent formation of the 3C-SiC single crystal film 11 on the surface of the single crystal silicon substrate 10.

The rate of temperature increase during the growth is in the range of 0.5 to 5°C/min, and preferably about 1°C/min.

Then, as the step of forming the 3C-SiC single crystal film, the temperature of the single crystal silicon substrate is raised to 800°C or higher and below 1200°C, and monomethylsilane or trimethylsilane is introduced as a raw material gas for SiC. This causes the formation of the 3C-SiC single crystal film 11.

In this case, the growth may be stopped once the temperature has reached a predetermined temperature, or the growth may be continued until the film thickness reaches a predetermined thickness. Alternatively, the growth may be stopped once the film thickness has reached a predetermined thickness during the temperature rise. Growing the film while varying the temperature enables the growth under continuously changing growth modes, which makes it possible to gradually accelerate the film formation rate.

In this case, the thickness of the 3C-SiC single crystal film 11 is set to greater than or equal to 50 nm and less than or equal to 200 nm. The thickness of greater than or equal to 50 nm sufficiently prevents the melt-back of Al or Ga during the subsequent growth of the GaN or AlₓGa₁₋ₓN (0 < x ≤ 1) layer. The thickness of less than or equal to 200 nm allows dislocations to be introduced throughout the wafer during the subsequent growth of the GaN or AlₓGa₁₋ₓN (0 < x ≤ 1) layer. In addition, the dislocations generated by the 3C-SiC growth will not extend, so that there is no increased likelihood of cracking. The thickness is preferably about 100 nm.

### (Second Step)

The second step is to fabricate the nitride semiconductor layer 31 on the 3C-SiC single crystal film 11 by vapor deposition.

In the first step, the thickness of the 3C-SiC single crystal film 11 is made less than or equal to 200 nm and then the second step is performed to thereby form dislocations throughout the single crystal silicon substrate 10, where the length (dislocation length) of each of the dislocations when seen in a planar projection onto the single crystal silicon substrate 10 is greater than or equal to 1 mm, and the density of the dislocations is greater than or equal to 10/cm².

A method for growing the nitride semiconductor layer 31 suitable for carrying out the present invention is described below.

### [1] Step of Introducing into a Reactor

The single crystal silicon substrate 10 on which the 3C-SiC single crystal film 11 has been grown is cleaned with chemicals and introduced into a reactor of an MOVPE apparatus.

Then, the reactor is filled with nitrogen or other high-purity inert gas to purge the reactor with the high-purity inert gas.

### [2] Step of Cleaning the Substrate Surface in the Reactor

The single crystal silicon substrate 10 on which the 3C-SiC single crystal film 11 has been grown is heated in the reactor to clean the surface of the substrate.

The intra-reactor pressure is reduced to 50 mbar before cleaning.

The intra-reactor pressure can be determined between 200 mbar and 30 mbar.

Cleaning is performed for 10 minutes with the supply of hydrogen or nitrogen into the reactor.

The temperature for cleaning can be determined between 1000°C and 1200°C in terms of the substrate surface temperature, and cleaning at 1050°C in particular can provide a clean surface.

### [3] Step of Growing the Intermediate Layer 12

In this step, source gases for Al, Ga, and N as raw materials are introduced at a specified intra-reactor pressure and substrate temperature to epitaxially grow the intermediate layer 12 made of AlN or AlₓGa₁₋ₓN (0 ≤ x < 1) on the substrate.

In this step, the growth is performed at an intra-reactor pressure of 50 mbar and a substrate temperature of 1120°C, for example.

Trimethylaluminum (TMAl) is used as the Al source, trimethylgallium (TMGa) as the Ga source, and ammonia (NH₃) as the N source. To obtain a mixed crystal with a desired Al composition, flow rates of the raw materials, TMAl and TMGa, are set so that the ratio of Al/Ga to be incorporated into the thin film is at a set ratio, by taking into account the material efficiency of the raw material gases.

In this step, AlN is grown with a TMAl flow rate of 0.24 L/min (240 sccm) in a standard state and a NH₃ flow rate of 2 L/min (2000 sccm). Hydrogen can be used as a carrier gas for TMAl, TMGa, and NH₃, for example. These conditions are exemplary and not limiting.

The device layer 21 made of a thin nitride semiconductor film is fabricated on the intermediate layer 12 by vapor deposition, such as by an MOVPE method or sputtering. For example, the device layer 21 is fabricated at 900°C to 1350°C by an MOVPE method.

### [4] Step of Growing the GaN or AlₓGa₁₋ₓN (0 < x ≤ 1) Layer 13

In this step, source gases for Ga and N as raw materials are introduced at a specified intra-reactor pressure and substrate temperature to epitaxially grow the GaN or AlₓGa₁₋ₓN (0 < x ≤ 1) layer 13 on the intermediate layer 12.

In this step, the growth is performed at an intra-reactor pressure of 200 mbar and a substrate temperature of 1120°C, for example.

Trimethylgallium (TMGa) is used as the Ga source, and ammonia (NH₃) as the N source. To obtain a mixed crystal with a desired Al composition, flow rates of the raw materials, TMAl and TMGa, are set so that the ratio of Al/Ga to be incorporated into the thin film is at a set ratio, by taking into account the material efficiency of the raw material gases. Hydrogen may be used as a carrier gas for TMAl, TMGa, and NH₃, for example. These conditions are exemplary and not limiting.

### [5] Step of Growing the Electron Supply Layer 14

In this step, source gases for Al, Ga, and N as raw materials are introduced at a specified intra-reactor pressure and substrate temperature to epitaxially grow the electron supply layer 14 made of AlₓGa₁₋ₓN (0 < x ≤ 1) on the GaN or AlₓGa₁₋ₓN (0 < x ≤ 1) layer 13.

In this step, the growth is performed at an intra-reactor pressure of 150 mbar and a substrate temperature of 1120°C, for example.

Trimethylaluminum (TMAl) was used as the Al source, trimethylgallium (TMGa) as the Ga source, and ammonia (NH₃) as the N source. To obtain a mixed crystal with a desired Al composition, flow rates of the raw materials, TMAl and TMGa, are set so that the ratio of Al/Ga to be incorporated into the thin film is at a set ratio, by taking into account the material efficiency of the raw material gases. Hydrogen can be used as a carrier gas for TMAl, TMGa, and NH₃, for example. These conditions are exemplary and not limiting.

The above steps can produce dislocations throughout the single crystal silicon substrate 10 without causing cracks. Further, the length (dislocation length) of each of the dislocations when seen in a planar projection onto the single crystal silicon substrate 10 can be made greater than or equal to 1 mm, and the density of the dislocations can be made greater than or equal to 10/cm².

By growing AlN or GaN after the step of forming the 3C-SiC single crystal film with the thickness of less than or equal to 200 nm, it is possible to form dislocations with the length of greater than or equal to 1 mm throughout the Si substrate at the density of greater than or equal to 10/cm², and such high-density formation of dislocations can reduce wafer warpage caused by the difference in linear expansion coefficient between GaN and Si.

### EXAMPLES

The present invention is now detailed with reference to Example, though the following description does not limit the present invention.

### (Example 1)

First, a 300 mm diameter (111) boron-doped single crystal silicon substrate with a regular resistance (resistivity: 10 Ω·cm, thickness: 775 µm) was provided.

The wafer was placed on a susceptor in a reactor of an RP-CVD apparatus, followed by H₂ annealing at 1080°C for 1 minute.

Subsequently, the temperature in the reactor was lowered to 300°C, followed by introducing trimethylsilane gas while raising the temperature to 1130°C at a temperature increase rate of 1°C/sec for nucleation of SiC and subsequent formation of the 3C-SiC single crystal film. The growth pressure during this process was constant at 100 Torr. After reaching 1130°C, the temperature was held for 10 minutes, and the 3C-SiC single crystal film was grown (film thickness: 100 nm).

Then, the substrate on which the 3C-SiC single crystal film was grown was introduced into a reactor of an MOCVD apparatus, which was purged with nitrogen to remove oxygen and moisture in the atmosphere.

Then, the intra-reactor pressure was reduced to 50 mbar, and the temperature was raised to 1050°C, followed by holding the temperature for 10 minutes in a hydrogen atmosphere to clean the surface layer.

Next, to film-form an intermediate layer serving as a buffer layer, the intra-reactor pressure was held at 50 mbar and the substrate temperature was held at 1020°C, and trimethylaluminum as the Al source, trimethylgallium as the Ga source, and ammonia as the nitrogen source were introduced into the reactor to film-form 180 nm of AlN and 580 nm of AlGaN.

Next, to grow a gallium nitride layer, the intra-reactor pressure was held at 200 mbar and the substrate temperature was held at 1120°C, and trimethylgallium and ammonia were introduced into the reactor to film-form 900 nm of GaN.

Subsequently, AlGaN serving as a charge supply layer was grown. Specifically, 25 nm of Al_{0.25}Ga_{0.75}N was grown at an intra-reactor pressure of 200 mbar and a substrate temperature of 1120°C.

Through the above processes, a substrate of Example 1 composed of the single crystal silicon substrate (775 µm) / 3C-SiC single crystal film (100 nm) / AlN (180 nm) / AlGaN (580 nm) / GaN (900 nm) / Al_{0.25}Ga_{0.75}N (25 nm) was fabricated.

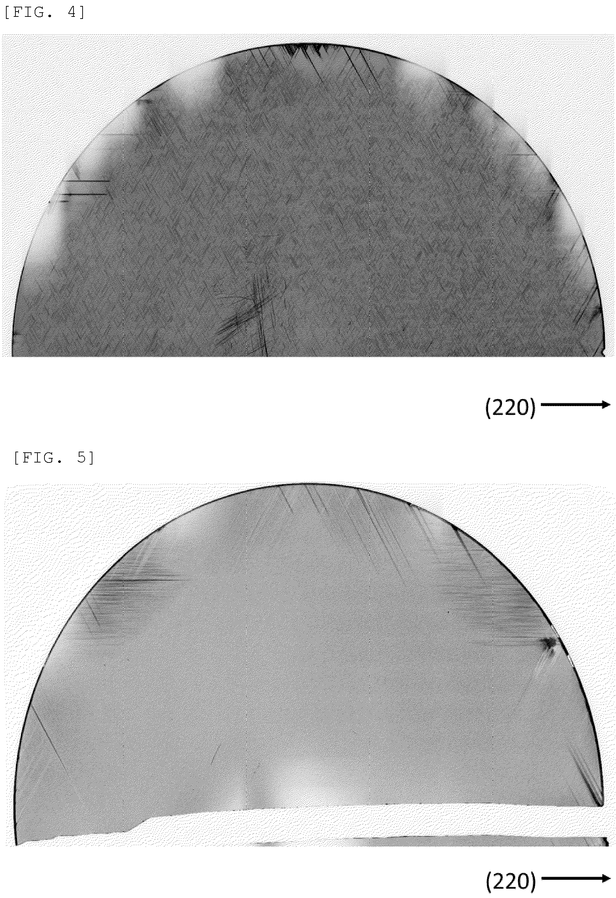

FIG. 4 illustrates the results of XRT measurement for the substrate of Example 1.

From FIG. 4, it was found that dislocations were formed throughout the single crystal silicon substrate and that the length (dislocation length) of each of the dislocations when seen in a planar projection onto the single crystal silicon substrate was greater than or equal to 1 mm and the density of the dislocations was greater than or equal to 10/cm².

### (Comparative Example 1)

A substrate of Comparative Example 1 was fabricated in the same manner as in Example 1, except that the thickness of the single crystal silicon substrate was set to 1.5 mm and that GaN was grown without growing 3C-SiC.

That is, a substrate of Comparative Example 1 composed of the single crystal silicon substrate (1.5 mm) / AlN (180 nm) / AlGaN (580 nm) / GaN (900 nm) / Al_{0.25}Ga_{0.75}N (25 nm) was fabricated.

FIG. 5 illustrates the results of XRT measurement for the substrate of Comparative Example 1.

From FIG. 5, it was found that the wafer was cracked and that dislocations occurred specifically in the portion where the single crystal silicon substrate was in contact with the susceptor of the apparatus.

### (Comparative Example 2)

A substrate of Comparative Example 2 was fabricated in the same manner as in Example 1, except that the thickness of the single crystal silicon substrate was set to 1.5 mm and that GaN was grown after growing 300 nm of 3C-SiC.

That is, a substrate of Comparative Example 2 composed of the single crystal silicon substrate (1.5 mm) / 3C-SiC single crystal film (300 nm) / AlN (180 nm) / AlGaN (580 nm) / GaN (900 nm) / Al_{0.25}Ga_{0.75}N (25 nm) was fabricated.

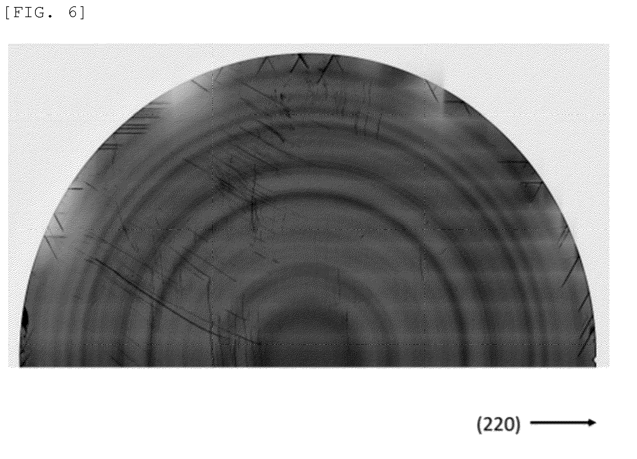

FIG. 6 illustrates the results of XRT measurement for the substrate of Comparative Example 2.

From FIG. 6, it was found that the wafer was cracked and that dislocations occurred specifically in the portion where the single crystal silicon substrate was in contact with the susceptor of the apparatus.

### (Comparative Example 3)

A substrate of Comparative Example 3 was fabricated in the same manner as in Example 1, except that GaN was grown without growing 3C-SiC.

That is, a substrate of Comparative Example 3 composed of the single crystal silicon substrate (775 µm) / AlN (180 nm) / AlGaN (580 nm) / GaN (900 nm) / Al_{0.25}Ga_{0.75}N (25 nm) was fabricated.

The wafer was damaged during the GaN process.

As described above, Example according to the present invention successfully produced a large diameter single crystal silicon substrate with a nitride semiconductor layer that was made using a regular thickness Si substrate and had less warpage and especially no cracks.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A single crystal silicon substrate with a nitride semiconductor layer, comprising:
a single crystal silicon substrate;
a 3C-SiC single crystal film epitaxially grown on the single crystal silicon substrate; and
a nitride semiconductor layer epitaxially grown on the 3C-SiC single crystal film, wherein
dislocations are formed throughout the single crystal silicon substrate,
a length (dislocation length) of each of the dislocations when seen in a planar projection onto the single crystal silicon substrate is greater than or equal to 1 mm, and
a density of the dislocations is greater than or equal to 10/cm².

2. The single crystal silicon substrate with a nitride semiconductor layer according to claim 1, wherein a thickness of the 3C-SiC single crystal film is greater than or equal to 50 nm and less than or equal to 200 nm.

3. The single crystal silicon substrate with a nitride semiconductor layer according to claim 1 or 2, wherein the nitride semiconductor layer is mainly composed of AlₓIn_{y}Ga_{1-x-y}N (0 ≤ x + y ≤ 1).

4. A method for producing a single crystal silicon substrate with a nitride semiconductor layer, comprising steps of:
epitaxially growing a 3C-SiC single crystal film on a single crystal silicon substrate; and
epitaxially growing a nitride semiconductor layer on the 3C-SiC single crystal film, wherein
in the step of epitaxially growing the 3C-SiC single crystal film on the single crystal silicon substrate, a thickness of the 3C-SiC single crystal film is made less than or equal to 200 nm and then the step of epitaxially growing the nitride semiconductor layer on the 3C-SiC single crystal film is performed to thereby form dislocations throughout the single crystal silicon substrate, wherein a length (dislocation length) of each of the dislocations when seen in a planar projection onto the single crystal silicon substrate is greater than or equal to 1 mm, and a density of the dislocations is greater than or equal to 10/cm².
